# EUROPÄISCHE PATENTSCHRIFT

(11) **EP 1 468 254 B1**
(45) Veröffentlichungstag und Bekanntmachung des Hinweises auf die Patenterteilung: **27.07.2005**
(21) Anmeldenummer: 02787886.7
(22) Anmeldetag: 30.11.2002
(51) Int. Cl.: G01D 5/347, H03M 1/28, G01D 5/249

(54) **POSITIONSMESSEINRICHTUNG**
POSITION MEASURING DEVICE
DISPOSITIF DE MESURE DE POSITION

(30) Priorität: 17.01.2002 DE 10201496; 23.09.2002 DE 10244235
(43) Veröffentlichungstag der Anmeldung: 20.10.2004
(73) Patentinhaber: Dr. Johannes Heidenhain GmbH, 83292 Traunreut (DE)
(72) Erfinder: STRASSER, Erich, 83308 Trostberg (DE); MITTMANN, Rudolf, 83342 Tacherting (DE)
(86) Internationale Anmeldenummer: PCT/EP2002/013547
(87) Internationale Veröffentlichungsnummer: WO 2003/060431

(56) Entgegenhaltungen:
- WO-A-02/01160

## Beschreibung

Die Erfindung betrifft eine Positionsmesseinrichtung zur Bestimmung der absoluten Position gemäß dem Anspruch 1 sowie ein Verfahren zur absoluten Positionsmessung gemäß dem Anspruch 9.

Auf vielen Gebieten werden vermehrt absolute Positionsmesseinrichtungen eingesetzt, bei denen die absolute Positionsinformation aus einer Codespur mit in Messrichtung hintereinander angeordneten Codeelementen abgeleitet wird. Die Codeelemente sind dabei in pseudozufälliger Verteilung vorgesehen, so dass eine bestimmte Anzahl von aufeinanderfolgenden Codeelementen jeweils ein Bitmuster bildet. Bei der Verschiebung der Abtasteinrichtung gegenüber der Codespur um ein einziges Codeelement wird bereits ein neues Bitmuster gebildet und über den gesamten absolut zu erfassenden Messbereich steht eine Folge von unterschiedlichen Bitmustern zur Verfügung.

Ein derartiger sequentieller Code wird als Kettencode oder als Pseudo-Random-Code bezeichnet.

In der Veröffentlichung "Absolute position measurement using optical detection of coded patterns", von J.T.M. Stevenson und J.R. Jordan in Journal of Physics E / Scientific Instruments 21 (1988), No. 12, Seiten 1140 bis 1145 ist angeführt, dass jedes Codeelement aus einer vorgegebenen Abfolge zweier Teilbereiche mit zueinander komplementären optischen Eigenschaften besteht.

In der Veröffentlichung ist auf die GB 2 126 444 A hingewiesen. Dort wird nun zur Erzeugung der binären Information bei einer derartigen Manchester-Codierung vorgeschlagen, die analogen Abtastsignale der Codebereiche mit einer vorgegebenen Triggerschwelle zu vergleichen und davon abhängig eine binäre Information 0 oder 1 zu generieren.

Dieser Vergleich mit einer fest vorgegebenen Triggerschwelle hat den Nachteil, dass Schwankungen in den analogen Abtastsignalen zur fehlerhaften Generierung der binären Informationen führen können.

Der Erfindung liegt daher die Aufgabe zugrunde, eine absolute Positionmesseinrichtung mit hoher Zuverlässigkeit bzw. Betriebssicherheit zu schaffen, mit der also eine möglichst fehlerfreie Erzeugung der absoluten Position möglich ist.

Diese Aufgabe wird durch die Merkmale des Anspruches 1 gelöst.

Der Erfindung liegt weiterhin die Aufgabe zugrunde, ein Verfahren zur Bestimmung einer absoluten Position anzugeben, mit dem eine möglichst fehlerfreie Erzeugung der binären Information und somit der absoluten Position ermöglicht wird.

Diese Aufgabe wird mit den Merkmalen des Anspruches 9 gelöst.

Aus der Veröffentlichung WO 02 011 60A ist eine Masseinrichtung und ein Massverfahren bekannt nach dem Oberbegriff der Ansprüche 1 und 9. Die Auswerteinheit ist hierbei basiert auf Fouriernanalyse.

Vorteilhafte Ausgestaltungen der Erfindung sind in den abhängigen Ansprüchen angegeben.

Die Erfindung wird anhand der Zeichnungen näher erläutert, dabei zeigen:
- Figur 1: eine Positionsmesseinrichtung in schematischer Darstellung;
- Figur 2: das Prinzip einer Fehlerprüfung;
- Figur 3: die Signale zur Fehlerprüfung gemäß Figur 2;
- Figur 4: eine Positionsmesseinrichtung mit einer inkrementalen Spur zur Erzeugung von Steuersignalen;
- Figur 5a: analoge Abtastsignale der inkrementalen Spur;
- Figur 5b: Steuersignale aus den analogen Abtastsignalen gemäß Figur 5a;
- Figur 6a: eine erste Abtastposition der Positionsmesseinrichtung;
- Figur 6b: eine zweite Abtastposition der Positionmesseinrichtung;
- Figur 6c: eine dritte Abtastposition der Positionsmesseinrichtung und
- Figur 6d: eine vierte Abtastposition der Positionsmesseinrichtung.

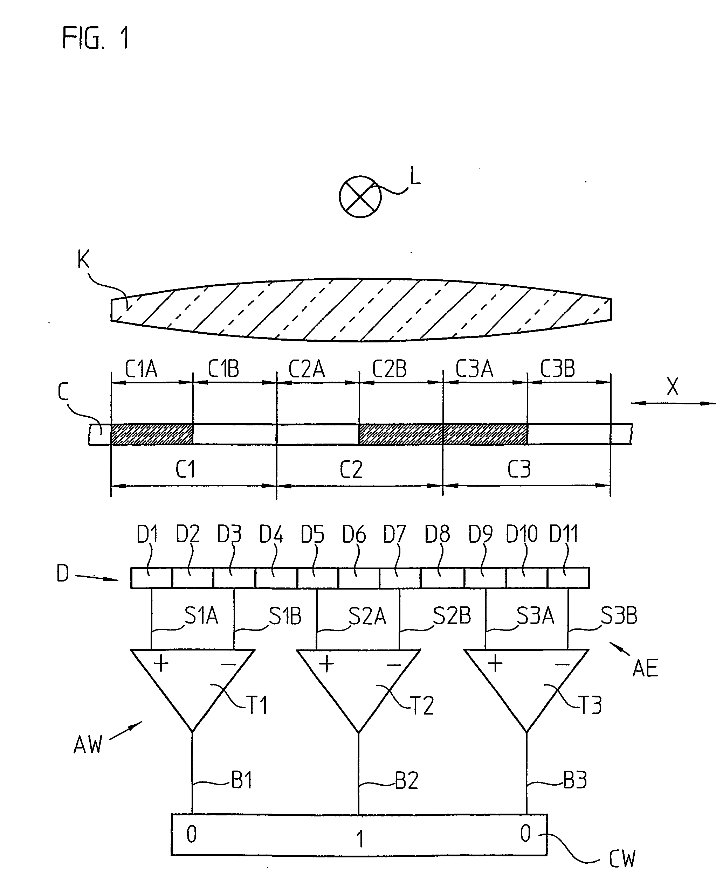

In Figur 1 ist eine erfindungsgemäß ausgestaltete Positionsmesseinrichtung schematisch dargestellt. Diese Positionsmesseinrichtung arbeitet nach dem optischen Abtastprinzip, bei dem ein Code C im Durchlichtverfahren abgetastet wird. Zur Abtastung des Codes C dient eine Abtasteinrichtung AE, die in Messrichtung X relativ zum Code C bewegbar angeordnet ist.

Der Code C besteht aus einer in Messrichtung X hintereinander angeordneten Folge von gleich langen Codeelementen C1, C2, C3. Jedes Codeelement C1, C2, C3 besteht wiederum aus zwei gleich langen in Messrichtung X nebeneinander unmittelbar aufeinanderfolgend angeordneten Teilbereichen A und B, die zueinander komplementär ausgebildet sind. Komplementär bedeutet dabei, dass sie inverse Eigenschaften besitzen, also beim optischen Abtastprinzip transparent und nicht transparent bzw. bei Auflicht-Abtastung reflektierend bzw. nicht reflektierend sind.

Der sequentielle Code C wird von der Abtasteinrichtung AE abgetastet, die eine Lichtquelle L enthält, deren Licht über eine Kollimatorlinse K mehrere aufeinanderfolgende Codeelemente C1, C2, C3 beleuchtet. Das Licht wird von dem Code C positionsabhängig moduliert, so dass hinter dem Code C eine positionsabhängige Lichtverteilung entsteht, die von einer Detektoreinheit D der Abtasteinrichtung AE erfasst wird.

Die Detektoreinheit D ist ein Zeilensensor mit einer in Messrichtung X angeordneten Folge von Detektorelementen D1 bis D11. Jedem Teilbereich A, B der Codeelemente C1, C2, C3 ist in jeder Relativlage zumindest ein Detektorelement D1 bis D11 eindeutig zugeordnet, so dass in jeder Relativlage der Detektoreinheit D gegenüber dem Code C ein Abtastsignal S1A bis S3B aus jedem Teilbereich A, B gewonnen wird. Diese Abtastsignale S1A bis S3B werden einer Auswerteeinrichtung AW zugeführt, welche die beiden Abtastsignale S1A, S1B; S2A, S2B; S3A, S3B der beiden Teilbereiche C1A, C1B; C2A, C2B; C2A, C2B; C3A, C3B eines Codeelementes C1, C2, C3 jeweils miteinander vergleicht und durch diesen Vergleich für jedes Codeelement C1, C2, C3 einen digitalen Wert bzw. ein Bit B1, B2, B3 erzeugt. Eine Folge mehrerer digitaler Werte B1, B2, B3 ergibt ein Codewort CW welches die absolute Position definiert. Bei einer Verschiebung der Detektoreinheit D gegenüber dem Code C um die Breite bzw. Länge eines Codeelementes C1, C2, C3 wird ein neues Codewort CW erzeugt und über den absolut zu vermessenden Messbereich wird eine Vielzahl von unterschiedlichen Codewörtern CW gebildet.

Figur 1 zeigt eine Momentanstellung des Codes C relativ zur Abtasteinrichtung AE. Die Detektorelemente D1 bis D11 sind aufeinanderfolgend in einem Abstand mit der halben Breite eines Teilbereiches C1A bis C3B des Codes C angeordnet. Dadurch ist sichergestellt, dass in jeder Position zumindest ein Detektorelement D1 bis D11 einem Teilbereich C1A bis C3B eindeutig zugeordnet ist und nicht einen Übergang zwischen zwei Teilbereichen C1A bis C3B abtastet. In der dargestellten Position wird der Teilbereich C1A vom Detektorelement D1 und der Teilbereich C1B vom Detektorelement D3 abgetastet. Die Detektorelemente D1, D3 erfassen die Lichtverteilung und erzeugen in Abhängigkeit der Lichtintensität ein analoges Abtastsignal S1A, S1 B proportional zur Lichtintensität. Da die beiden Teilbereiche C1A und C1B komplementär zueinander ausgebildet sind, ist auch die Intensität der Abtastsignale S1A und S1B invers zueinander, die Signalpegel sind also weit voneinander beabstandet.

Dieser Signalabstand wird nun zur Erzeugung der binären Information B1 ausgenutzt, indem geprüft wird, welches der beiden Abtastsignale S1A, S1B des Codeelementes C1 größer ist. Diese Prüfung kann durch Quotientenbildung oder durch Differenzbildung erfolgen. Am Beispiel wird die Differenzbildung eingesetzt, wozu gemäß Figur 1 als Vergleichseinrichtung ein Triggerbaustein T1 dient. Der Triggerbaustein T1 erzeugt B1=0, wenn S1A kleiner S1B und B1=1, wenn S1A größer S1B ist. In gleicher Weise werden binäre Informationen B2 und B3 durch Abtastung der Codeelemente C2, C3 und Vergleich der analogen Abtastsignale S2A, S2B; S3A, S3B der Teilbereiche C2A, C2B; C3A, C3B jeweils eines Codeelementes C2, C3 durch Triggerbausteine T2, T3 gewonnen.

Einer ersten Abfolge der komplementär zueinander ausgebildeten Teilbereich A, B wird also ein erster digitaler Wert und einer zweiten Abfolge der komplementär zueinander ausgebildeten Teilbereiche A, B wird ein zweiter digitaler Wert zugeordnet. Im Beispiel wird der Abfolge opak → transparent der Wert 0 und der Abfolge transparent → opak der Wert 1 zugeordnet.

Da die beiden Teilbereiche A und B jedes Codeelementes C1, C2, C3 zueinander komplementär sind, ist der Störabstand der Abtastsignale S sehr groß. Eine Veränderung der Lichtintensität der Lichtquelle L beeinflusst die Abtastsignale S beider Teilbereiche A und B gleichermaßen.

Aufgrund der komplementären Ausgestaltung jeweils zweier Teilbereiche A, B eines Codeelementes C1, C2, C3 müssen bei korrekter Betriebsweise der Positionsmesseinrichtung durch Abtastung dieser Teilbereich A, B jeweils analoge Abtastsignale S erzeugt werden, deren Differenz einen vorgegebenen Wert übersteigt. Durch Beobachtung dieses Differenzwertes ist eine gute Fehlerprüfung möglich. Die Grundlage dieser Fehlerprüfung ist, dass davon ausgegangen werden kann, dass bei Unterschreiten des Differenzwertes um einen vorgegebenen Betrag die binäre Information B1, B2, B3 unsicher ist und daher zu dieser binären Information B1, B2, B3 ein Fehlersignal F1 erzeugt wird.

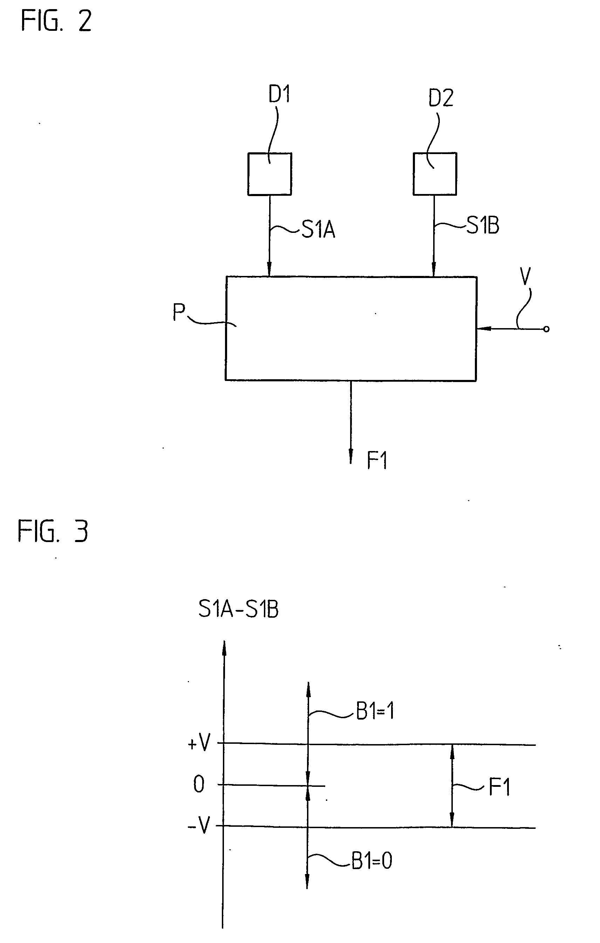

Das Prinzip der Erzeugung des Fehlersignals F1 ist in Figur 2 dargestellt. Die analogen Abtastsignale S1A und S1B des Codeelementes C1 werden einer Fehlerprüfeinrichtung P zugeführt. Die Fehlerprüfeinrichtung P vergleicht S1A und S1B durch Differenzbildung (S1A - S1B) und prüft, ob der Differenzbetrag einen vorgegebenen Vergleichswert V übersteigt oder nicht übersteigt. Wenn der Differenzbetrag (S1A - S1B) den vorgegebenen Vergleichswert V nicht übersteigt, wird ein Fehlersignal F1 ausgegeben. In Figur 3 sind diese Signalverhältnisse dargestellt.

Die Anordnung der beiden Teilbereiche A und B jedes Codeelementes C1, C2, C3 aufeinanderfolgend direkt nebeneinander in Messrichtung X hat den Vorteil, dass die Detektorelemente D1 bis D11 in einem geringen Abstand in Messrichtung X nebeneinander angeordnet werden können und somit die Positionsmesseinrichtung gegen Verdrehung der Detektoreinheit D gegenüber dem Code C, also gegen Moiré-Schwankungen unempfindlich ist. Weiterhin ist die Störempfindlichkeit gegen Verschmutzungen gering, da davon ausgegangen werden kann, dass beide Teilbereiche A und B eines Codeelementes C1, C2, C3 gleichermaßen beeinflusst werden.

Am Beispiel der Detektorelemente D1 und D2 ist in Figur 1 leicht erkennbar, dass bei einer Verschiebung des Codes C um die Länge eines Teilbereiches A, B nach links das Detektorelement D1 den Teilbereich C1B und das Detektorelement D3 den Teilbereich C2A abtastet, also Teilbereiche zweier Codeelemente C1, C2. Der Triggerbaustein T1 kann somit keine einem Codeelement C1, C2, C3 zugeordnete binäre Information B1, B2, B3 liefern. Nachfolgend werden nun Maßnahmen erläutert, mit denen sichergestellt wird, dass zur Codeworterzeugung die korrekten Detektorelemente D1 bis D11 verwendet werden, also die Detektorelemente D1 bis D11, die jeweils die Teilbereiche eines einzigen Codeelementes C1, C2, C3 abtasten.

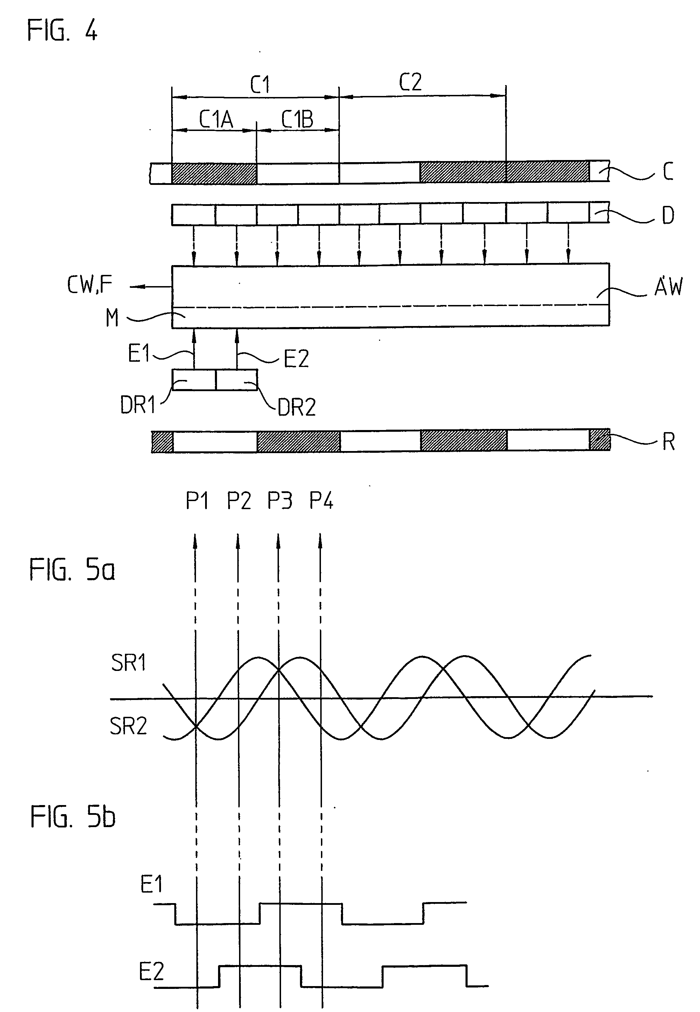

Anhand der Figuren 4 bis 6 wird eine bevorzugte Maßnahme hierfür beschrieben. Parallel neben dem Code C ist gemäß Figur 4 eine Inkrementalspur R mit einer periodischen Teilung der Periodenlänge entsprechend der Länge eines Codeelementes C1, C2, C3 angeordnet. Die Inkrementalspur R wird in bekannter Weise von zumindest zwei um % Teilungsperiode in Messrichtung X gegeneinander versetzten Detektorelementen DR1, DR2 zur Erzeugung zweier um 90° gegeneinander phasenverschobener analoger Abtastsignale SR1, SR2 abgetastet. Diese analogen Abtastsignale SR1, SR2 werden in bekannter Weise interpoliert und der interpolierte Positionswert wird mit dem Codewort CW kombiniert, wodurch die grobe absolute Positionsmessung durch die hochauflösende Inkrementalmessung verfeinert wird.

Durch die Inkrementalmessung wird die Länge jedes Codeelementes C1, C2, C3 interpoliert. Durch den Interpolationswert ist nun auf einfache Weise eine Unterscheidung des rechten und linken Teilbereiches eines Codeelementes C1, C2, C3 möglich. Zur Unterscheidung der Teilbereiche A und B reicht eine 4-fach Interpolation, also eine einfach Triggerung der analogen Abtastsignale SR1, SR2 aus. Die dadurch gewonnene Bitkombination aus den Digitalsignalen E1, E2 definiert die Reihenfolge der Teilbereiche A, B eindeutig und sie dient als Steuersignal zur Festlegung der Detektorelemente D1 bis D11, aus denen ein korrektes Codewort CW erzeugbar ist. Die Digitalsignale E1, E2 definieren also, welche Abtastsignale S miteinander verglichen werden und aus welchen Abtastsignalen S digitale Werte B1, B2, B3 für das Codewort CW gewonnen werden können.

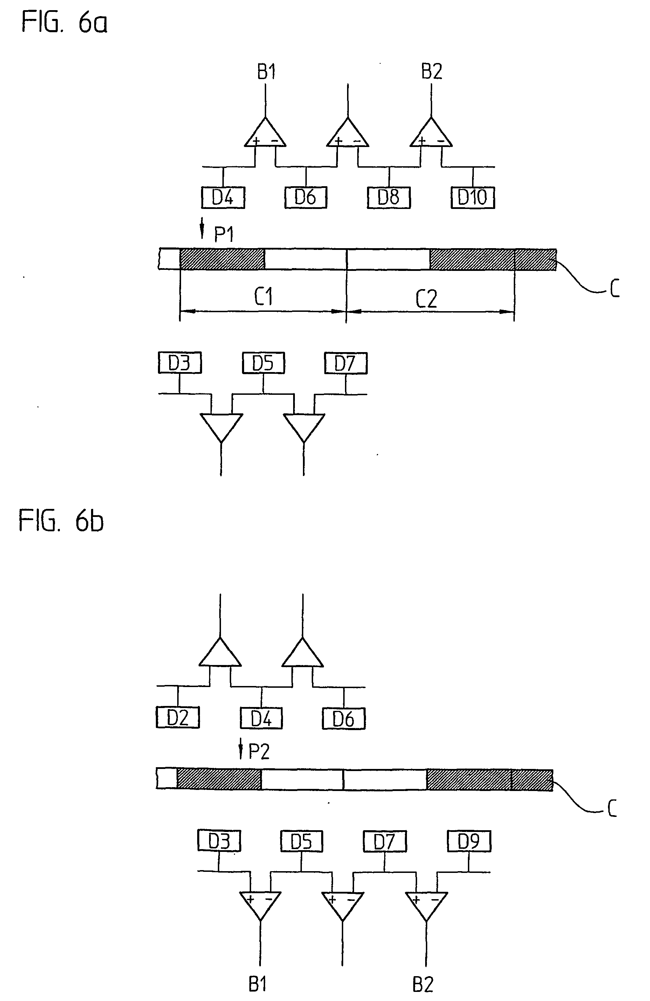

Zur weiteren Erläuterung dieses Verfahrens sind in den Figuren 6a bis 6d vier verschiedene Positionen P1, P2, P3, P4 des Codes C gegenüber der Detektoreinheit D dargestellt. Die Detektorelemente D1 bis D11 sind in Messrichtung X in Abständen entsprechend der halben Länge eines Teilbereiches A, B angeordnet und jeweils zwei Detektorelemente D1 bis D11, die in einem gegenseitigen Abstand entsprechend der Länge eines Teilbereiches A, B angeordnet sind, sind in Differenz geschaltet.

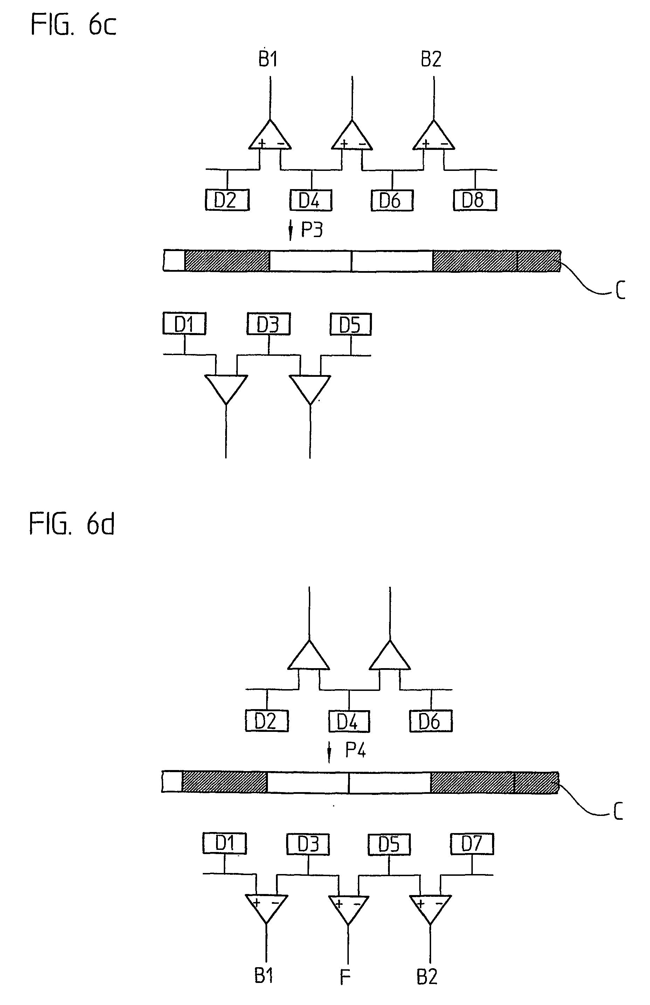

In Figur 6a ist die Position P1 dargestellt, bei der aus der Inkrementalspur R die Information E1=0 und E2=0 gewonnen wird. Das Bit B1 des Codeelementes C1 wird durch Differenzbildung der Detektorelemente D4 und D6, also (D4-D6) gebildet. Bei der Position P2 gemäß Figur 6b ist E1=0 und E2=1, so dass durch eine Steuereinheit M die Detektorelemente D3 und D5 ausgewählt werden. Bei der Position P3 gemäß Figur 6c ist E1=1 und E2=1, so dass von der Steuereinheit M die Detektorelemente D2 und D4 zur Differenzbildung ausgewählt werden. Bei der Position P4 gemäß Figur 6d ist E1=1 und E2=0, so dass die Detektorelemente D1 und D3 ausgewählt werden.

In gleicher Weise werden die korrekten Detektorelemente zur Bildung der weiteren Bits des Codewortes CW ermittelt. Wenn beispielsweise zur Bildung des Bits B1 die Detektorelemente D1 und D3 ausgewählt worden sind, dienen zur Bildung des Bits B2 die Detektorelemente D5 und D7 sowie zur Bildung des Bits B3 die Detektorelemente D9 und D11, wie in Figur 1 dargestellt ist. Wobei in Figur 1 nur die in dieser Momentanstellung verwendeten Triggerbausteine T1, T2, T3 dargestellt sind.

Eine weitere Möglichkeit zur Ermittlung der korrekten Detektorelemente D1 bis D11 bzw. der korrekten analogen Abtastsignale S besteht darin, dass alle Detektorelemente D1 bis D11, die im Abstand der Länge eines Teilbereiches A, B voneinander beabstandet sind miteinander verglichen werden. Im Abstand eines Codeelementes C1, C2, C3 gibt es nun Detektorpaare D1, D3 und D5, D7 - am Beispiel der in Figur 6d dargestellten Momentanposition P4- die in gewünschter Weise jeweils die Differenz der Teilbereiche A, B eines Codeelementes C1, C2 abtasten. Die weiteren Detektorpaare D3, D5 tasten aufeinanderfolgende Teilbereiche B, A zweier aufeinanderfolgender Codeelemente C1, C2 ab und erzeugen somit mit der anhand Figur 2 erläuterten Fehlerprüfeinrichtung P ein Fehlersignal F1. Um nun die korrekten Detektorelemente D1 bis D11 zu ermitteln, wird die Detektorgruppe D1, D3; D5, D7 gesucht, bei der am wenigsten Fehlersignale F auftreten. Im Detail ist bzw. sind zur Durchführung dieser zweiten möglichen Maßnahme folgende Anordnung bzw. folgende Verfahrensschritte erforderlich:
- Detektorelemente D1 bis D11 sind in Messrichtung X in Abständen entsprechend der halben Länge eines Teilbereiches A, B angeordnet;
- die Detektorelemente D1 bis D11 bilden eine erste Gruppe (in den Figuren 6a bis 6d geradzahlig nummerierte Detektorelemente D2, D4, D6, D8, D10) mit einem gegenseitigen Abstand entsprechend der Länge eines Teilbereiches A, B;
- die Detektorelemente D1 bis D11 bilden eine zweite Gruppe (in den Figuren 6a bis 6d ungeradzahlig nummerierte Detektorelemente D1, D3, D5, D7, D9) mit einem gegenseitigen Abstand entsprechend der Länge eines Teilbereiches A, B;
- die Detektorelemente D2, D4, D6, D8, D10 der ersten Gruppe sind gegenüber den Detektorelementen D1, D3, D5, D7, D9 der zweiten Gruppe um die halbe Länge eines Teilbereiches A, B versetzt angeordnet;
- unmittelbar aufeinanderfolgende Detektorelemente einer Gruppe sind jeweils in Differenz geschaltet;
- von den beiden Gruppen werden nun die Vergleichsergebnisse der Detektorelementenpaare in einem Raster entsprechend der Länge eines Codeelementes C1, C2, C3 zur Bildung des Codewortes CW verwendet, dessen Folge am wenigsten Fehler F erzeugt, gemäß Figur 6d also die Folge (D1-D3)=B1, (D5-D7)=B2 usw.

Die beiden Teilbereiche A, B eines jeden Codeelementes C1, C2, C3 können optisch abtastbar ausgebildet sein, wobei dann ein Teilbereich A für das Abtastlicht transparent oder reflektierend und der anderen Teilbereich B opak oder nicht reflektierend ausgebildet ist. Die Erfindung ist aber nicht auf das optische Abtastprinzip beschränkt.

Die absolute Positionsmesseinrichtung kann zur Messung von linearen oder rotatorischen Bewegungen eingesetzt werden, wobei der Code C an einem der beweglichen Objekte und die Abtasteinrichtung AE am anderen der zu messenden Objekte angebracht ist. Der Code C kann dabei direkt an dem zu messenden Objekt angebracht sein oder auf einem Maßstab, der dann wiederum mit dem zu messenden Objekt gekoppelt ist.

Die zu messenden Objekte können dabei der Tisch und der Schlitten einer Werkzeugmaschine, einer Koordinatenmessmaschine oder der Rotor und der Stator eines Elektromotors sein.

## Patentansprüche

1. Positionsmesseinrichtung mit
- einem Code (C), bestehend aus einer Folge von in Messrichtung X hintereinander angeordneten Codeelementen (C1, C2, C3), wobei jedes Codeelement (C1, C2, C3) jeweils aus zwei Teilbereichen (A, B) besteht, die zueinander komplementär sind und in Messrichtung X aufeinanderfolgend angeordnet sind;
- einer Abtasteinrichtung (AE) mit mehreren Detektorelementen (D1 bis D11) zur Abtastung mehrerer Codeelemente (C1, C2, C3) und zur Bildung zumindest eines Abtastsignals (S) innerhalb eines jeden Teilbereichs (A, B) der abgetasteten Codeelemente (C1, C2, C3) **gekennzeichnet durch**
- eine Auswerteeinheit (AW) mit einer Vergleichseinrichtung (T1, T2, T3), die jeweils die Abtastsignale (S) der Teilbereiche (A, B) eines Codeelementes (C1, C2, C3) miteinander vergleicht und in Abhängigkeit des Vergleichsergebnisses eine binäre Information (B1, B2, B3) für das Codeelement (C1, C2, C3) bildet.

2. Positionsmesseinrichtung nach Anspruch 1, wobei die Vergleichseinrichtung (T1, T2, T3) eine Einrichtung zur Bildung der Differenz der analogen Abtastsignale (S) beider Teilbereiche (A, B) eines Codeelementes (C1, C2, C3) ist.

3. Positionsmesseinrichtung nach Anspruch 1 oder 2, wobei die Abtastsignale (S) aus aufeinanderfolgenden Teilbereichen (A, B) jeweils einer Vergleichseinrichtung (T1. T2, T3) zugeführt sind und die Auswerteeinheit (AW) eine Steuereinheit (M) aufweist, die dazu ausgelegt ist, sicherzustellen, dass die binären Informationen (B1, B2, B3) jeweils aus den beiden Teilbereichen (A, B) eines Codeelementes (C1, C2, C3) gebildet werden.

4. Positionsmesseinrichtung nach Anspruch 3, wobei parallel zum Code (C) zumindest eine Spur (R) angeordnet ist, dessen Information (E1, E2) der Steuereinheit (M) zugeführt ist und wobei aufgrund dieser Information (E1, E2) die Abtastsignale (S) aufeinanderfolgender Teilbereiche (A, B) eines Codeelementes (C1, C2, C3) zur Bildung der binären Informationen (B1, B2, B3) ausgewählt werden.

5. Positionsmesseinrichtung nach Anspruch 4, wobei die Informationsspur (R) eine periodische inkrementale Teilung ist.

6. Positionsmesseinrichtung nach einem der vorhergehenden Ansprüche, wobei die Auswerteeinheit (AW) eine Fehlerprüfeinrichtung (P) aufweist, die dazu ausgelegt ist, die Differenz der Abtastsignale (S) der Teilbereiche (A, B) eines Codeelementes (C1, C2, C3) mit einer Solldifferenz zu vergleichen und bei Unterschreiten der Solldifferenz ein Fehlersignal (F1) abzugeben.

7. Positionsmesseinrichtung nach einem der vorhergehenden Ansprüche, wobei die beiden Teilbereiche (A, B) eines Codeelementes (C1, C2, C3) zueinander komplementäre optische Eigenschaften besitzen.

8. Positionsmesseinrichtung nach einem der vorhergehenden Ansprüche, wobei die Detektorelemente (D1 bis D11) in Messrichtung X in Abständen entsprechend der halben Länge eines Teilbereiches (A, B) angeordnet sind und jeweils zwei Detektorelemente (D1 bis D11), die in einem gegenseitigen Abstand entsprechend der Länge eines Teilbereiches (A, B) angeordnet sind in Differenz geschaltet sind.

9. Verfahren zur absoluten Positionsmessung mit folgenden Verfahrensschritten
- Abtasten eines Codes (C), bestehend aus einer Folge von in Messrichtung X hintereinander angeordneten Codeelementen (C1, C2, C3), wobei die Codeelemente (C1, C2, C3) jeweils aus zwei Teilbereichen (A, B) bestehen, die zueinander komplementär sind und in Messrichtung X aufeinanderfolgend angeordnet sind;
- Erzeugen zumindest eines Abtastsignals (S) innerhalb eines jeden Teilbereichs (A, B) der abgetasteten Codeelemente (C1, C2, C3) **gekennzeichnet durch** das
- Vergleichen der Abtastsignale (S) der Teilbereiche (A, B) eines Codeelementes (C1, C2, C3) miteinander und
- Bilden einer binären Information (B1, 82, B3) aus dem Vergleich.

10. Verfahren nach Anspruch 9, wobei der Vergleich eine Differenzbildung der analogen Abtastsignale (S) der Teilbereiche (A, B) ist.

11. Verfahren nach einem der Ansprüche 9 oder 10, mit dem Verfahrensschritt
- Vergleich der Abtastsignale (S) jeweils unmittelbar aufeinanderfolgender Teilbereiche (A, B) und Auswahl der Abtastsignale (S), welche jeweils durch Abtastung der Teilbereiche (A, B) eines Codewortes (C1, C2, C3) gebildet sind.

12. Verfahren nach Anspruch 11, wobei die Auswahl durch ein Steuersignal (E1, E2) erfolgt, das durch Abtastung zumindest einer Informationsspur (R) gewonnen ist.

13. Verfahren nach einem der vorhergehenden Ansprüche 9 bis 12, wobei die Differenz der Abtastsignale (S) der Teilbereiche (A, B) eines Codeelementes (C1, C2, C3) gebildet wird, die Differenz mit einer Solldifferenz verglichen wird und bei Unterschreiten der Solldifferenz ein Fehlersignal (F1) gebildet wird.

14. Verfahren nach einem der vorhergehenden Ansprüche 9 bis 11, wobei die Detektorelemente (D1 bis D11) in Messrichtung X in Abständen entsprechend der halben Länge eines Teilbereiches (A, B) angeordnet sind und jeweils aus zwei Detektorelementen (D1 bis D11), die in einem gegenseitigen Abstand entsprechend der Länge eines Teilbereiches (A, B) angeordnet sind die Differenz gebildet wird.

15. Verfahren nach Anspruch 14, wobei die Differenz jeweils mit einer Solldifferenz verglichen wird und bei Unterschreiten der Solldifferenz ein Fehlersignal (F1) gebildet wird und die durch die Differenzbildung gewonnene binäre Information (B1, B2, B3) der Detektorelementenpaare in einem Raster entsprechend der Länge eines Codeelementes (C1, C2, C3) zur Bildung des Codewortes CW ausgewählt werden, dessen Folge am wenigsten Fehler (F) erzeugt.

## Claims

1. Position measuring device, having
- a code (C), comprising a sequence of code elements (C1, C2, C3) which are disposed one behind the other in the measuring direction X, each code element (C1, C2, C3) comprising respectively two partial regions (A, B), which are complementary to each other and are disposed sequentially in the measuring direction X,
- a scanning device (AE) with a plurality of detector elements (D 1 to D11) for scanning a plurality of code elements (C1, C2, C3) and for forming at least one scanning signal (S) within each partial region (A, B) of the scanned code elements (C 1, C2, C3), **characterised by**
- an evaluation unit (AW) with a comparison device (T1, T2, T3), which compares the scanning signals (S) of the partial regions (A, B) of one code element (C1, C2, C3) respectively with each other and forms binary information (B 1, B2, B3) for the code element (C1, C2, C3) as a function of the result of the comparison.

2. Position measuring device according to claim 1, the comparison device (T1, T2, T3) being a device for subtraction of the analogue scanning signals (S) of two partial regions (A, B) of one code element (C 1, C2, C3).

3. Position measuring device according to claim 1 or 2, the scanning signals (S) from sequential partial regions (A, B) being supplied respectively to a comparison device (T1, T2. T3), and the evaluation unit (AW) having a control unit (M), which is designed to ensure that the binary information (B1, B2, B3) is formed respectively from the two partial regions (A, B) of one code element (C1, C2, C3).

4. Position measuring device according to claim 3, at least one track (R) being disposed parallel to the code (C), the information (E1, E2) of which is supplied to the control unit (M) and, on the basis of this information (E1, E2), the scanning signals (S) of sequential partial regions (A, B) of one code element (C1, C2, C3) being selected for forming the binary information (B1, B2, B3).

5. Position measuring device according to claim 4, the information track (R) being a periodic incremental graduation.

6. Position measuring device according to one of the preceding claims, the evaluation unit (AW) having an error check device (P), which is designed for comparing the difference of the scanning signals (S) of the partial regions (A, B) of one code element (C1, C2, C3) with a nominal difference and, upon the nominal difference being fallen below, for outputting an error signal (F1).

7. Position measuring device according to one of the preceding claims, the two partial regions (A, B) of one code element (C1, C2, C3) having optical properties which are complementary to each other.

8. Position measuring device according to one of the preceding claims, the detector elements (D 1 to D11) being disposed in the measuring direction X at spacings corresponding to half the length of one partial region (A, B), and respectively two detector elements (D 1 to D11), which are disposed at a mutual spacing corresponding to the length of one partial region (A, B), being differentially connected.

9. Method for absolute position measuring, having the following method steps
- scanning a code (C) comprising a sequence of code elements (C1, C2, C3) which are disposed one behind the other in the measuring direction X, the code elements (C1, C2, C3) comprising respectively two partial regions (A, B), which are complementary relative to each other and are disposed sequentially in the measuring direction X,
- production of at least one scanning signal (S) within each partial region (A, B) of the scanned code elements (C1, C2, C3), **characterised by**
- comparison of the scanning signals (S) of the partial regions (A, B) of one code element (C1, C2, C3) with each other, and
- formation of binary information (B1, B2, B3) from the comparison.

10. Method according to claim 9, the comparison being the subtraction of the analogue scanning signals (S) of the partial regions (A, B).

11. Method according to one of claims 9 or 10 with the method step
- comparison of the scanning signals (S) of respectively directly sequential partial regions (A, B), and selection of the scanning signals (S), which are formed respectively by scanning of the partial regions (A, B) of one code word (C1, C2, C3).

12. Method according to claim 11, the selection being effected by means of a control signal (E1, E2) which is obtained by scanning of at least one information track (R).

13. Method according to one of the preceding claims 9 to 12, the difference of the scanning signals (S) of the partial regions (A, B) of one code element (C1, C2, C3) being formed, the difference being compared with a nominal difference, and an error signal (F1) being formed upon the nominal difference being fallen below.

14. Method according to one of preceding claims 9 to 11, the detector elements (D 1 to D 11) being disposed in the measuring direction X at spacings corresponding to half the length of one partial region (A, B), and the difference being formed respectively from two detector elements (D 1 to D 11) which are disposed at a mutual spacing corresponding to the length of one partial region (A, B).

15. Method according to claim 14, the difference respectively being compared with a nominal difference and an error signal (F1) being formed upon the nominal difference being fallen below, and the binary information (B1, B2, B3), obtained by means of subtraction, of the pairs of detector elements being selected in a pattern corresponding to the length of one code element (C1, C2, C3) in order to form the code word CW, the sequence of which produces the least errors (F).

## Revendications

1. Dispositif de mesure de position comprenant
- un code (C) formé d'une suite d'éléments de code (C1, C2, C3) disposés les uns à la suite des autres dans la direction de mesure X, chaque élément de code (C1, C2, C3) étant constitué de deux zones partielles (A, B) qui sont mutuellement complémentaires et sont disposées l'une à la suite d l'autre dans la direction de mesure X;
- une unité de palpage (AE) avec plusieurs éléments détecteurs (D1 à D11) pour le palpage de plusieurs éléments de code (C1, C2, C3) et pour la formation d'au moins un signal de palpage (S) à l'intérieur de chaque zone partielle (A, B) des éléments de code (C1, C2, C3) palpés, **caractérisé par**
- une unité de traitement (AW) comportant un dispositif de comparaison (T1, T2, T3) qui compare entre eux les signaux de palpage (S) des zones partielles (A, B) d'un élément de code (C1, C2, C3) et forme une information binaire (B1, B2, B3) pour l'élément de code (C1, C2, C3), en fonction du résultat de la comparaison.

2. Dispositif de mesure de position selon la revendication 1, dans lequel le dispositif de comparaison (T1, T2, T3) est un dispositif pour former la différence des signaux de palpage (S) analogiques des deux zones partielles (A, B) d'un élément de code (C1, C2, C3).

3. Dispositif de mesure de position selon la revendication 1 ou 2, dans lequel les signaux de palpage (S) provenant de zones partielles (A, B) successives sont transmis respectivement à un dispositif de comparaison (T1, T2, T3), et l'unité de traitement (AW) présente une unité de commande (M) qui est conçue pour garantir que les informations binaires (B1, B2, B3) sont formées chaque fois à partir des deux zones partielles (A, B) d'un élément de code (C1, C2, C3).

4. Dispositif de mesure de position selon la revendication 3, dans lequel il est prévu, parallèlement au code (C), au moins une piste (R) dont l'information (E1, E2) est transmise à l'unité de commande (M), et dans lequel, sur la base de cette information (E1, E2), les signaux de palpage (S) de zones partielles (A, B) successives d'un élément de code (C1, C2, C3) sont sélectionnés pour former les informations binaires (B1, B2, B3).

5. Dispositif de mesure de position selon la revendication 4, dans lequel la piste d'information (R) est une graduation incrémentale périodique.

6. Dispositif de mesure de position selon une des revendications précédentes, dans lequel l'unité de traitement (AW) présente un dispositif détecteur d'erreurs (P) qui est conçu pour comparer la différence des signaux de palpage (S) des zones partielles (A, B) d'un élément de code (C1, C2, C3) avec une différence de consigne et pour émettre un signal d'erreur (F1) en cas de passage en dessous de cette différence de consigne.

7. Dispositif de mesure de position selon une des revendications précédentes, dans lequel les deux zones partielles (A, B) d'un élément de code (C1, C2, C3) possèdent des propriétés optiques mutuellement complémentaires.

8. Dispositif de mesure de position selon une des revendications précédentes, dans lequel les éléments détecteurs (D1 à D 11) sont disposés dans la direction de mesure X, à des intervalles correspondant à la moitié de la longueur d'une zone partielle (A, B), et chaque fois deux éléments détecteurs (D1 à D11), qui sont disposés avec un espacement réciproque correspondant à la longueur d'une zone partielle (A, B), sont connectés dans un branchement différentiel.

9. Procédé de mesure de position absolue comprenant les étapes suivantes:
- palpage d'un code (C) formé d'une suite d'éléments de code (C1, C2, C3) disposés les uns à la suite des autres dans la direction de mesure X, chaque élément de code (C1, C2, C3) étant constitué de deux zones partielles (A, B) qui sont mutuellement complémentaires et sont disposées l'une à la suite d l'autre dans la direction de mesure X;
- production d'au moins un signal de palpage (S) à l'intérieur de chaque zone partielle (A, B) des éléments de code (C1, C2, C3) palpés, **caractérisé par**
- la comparaison des signaux de palpage (S) des zones partielles (A, B) d'un élément de code (C1, C2, C3) et
- la formation d'une information binaire (B1, B2, B3) à partir de cette comparaison.

10. Procédé selon la revendication 9, selon lequel la comparaison est une formation de la différence entre les signaux de palpage (S) analogiques des zones partielles (A, B).

11. Procédé selon une des revendications 9 ou 10, comprenant l'étape de
- comparaison des signaux de palpage (S) de zones partielles (A, B) consécutives et de sélection des signaux de palpage (S) qui sont formés respectivement par palpage des zones partielles (A, B) d'un mot-code (C1, C2, C3).

12. Procédé selon la revendication 11, selon lequel la sélection est opérée à l'aide d'un signal de commande (E1, E2) qui est produit par palpage d'au moins une piste d'information (R).

13. Procédé selon une des revendications précédentes 9 à 12, selon lequel on forme la différence des signaux de palpage (S) des zones partielles (A, B) d'un élément de code (C1, C2, C3), on compare cette différence avec une différence de consigne et on produit un signal d'erreur (F1) lorsque cette différence est inférieure à la différence de consigne.

14. Procédé selon une des revendications précédentes 9 à 11, selon lequel les éléments détecteurs (D1 à D11) sont disposés dans la direction de mesure X, à des intervalles correspondant à la moitié de la longueur d'une zone partielle (A, B), et la différence est formée chaque fois à partir de deux éléments détecteurs (D1 à D11) qui sont disposés avec un espacement réciproque correspondant à la longueur d'une zone partielle (A, B).

15. Procédé selon la revendication 14, selon lequel la différence est comparée avec une différence de consigne et, en cas de passage en dessous de la différence de consigne, il est produit un signal d'erreur (F1) et l'information binaire (B1, B2, B3) des paires d'éléments détecteurs, obtenue par la formation de la différence, est sélectionnée dans une grille, en fonction de la longueur d'un élément de code (C1, C2, C3), pour former le mot-code CW dont la suite produit le moins d'erreurs (F).
